# DEMANDE DE BREVET EUROPEEN

(11) **EP 3 896 414 A2**
(43) Date de publication de la demande: **20.10.2021**
(21) Numéro de dépôt: 21168666.2
(22) Date de dépôt: 15.04.2021
(51) Int. Cl.: G01K 7/01, G01R 31/26, H03K 17/082

(54) **SYSTÈME D'INTERRUPTEUR AVEC DISPOSITIF DE DÉTERMINATION DE TEMPÉRATURE, INSTALLATION ÉLECTRIQUE COMPORTANT UN TEL SYSTÈME D'INTERRUPTEUR ET PROCÉDÉ CORRESPONDANT**

(30) Priorité: 17.04.2020 FR 2003913
(71) Demandeur: Valeo Siemens eAutomotive France SAS, 95800 Cergy (FR)
(72) Inventeur: KOLLI, Abdelfatah, 95800 Cergy (FR); CHELGHOUM, Reda, 95800 Cergy (FR); ASKEUR, Mimoun, 95800 Cergy (FR); KAPANGALA, Bernoly, 1050 Ixelles (BE)
(74) Mandataire: Novembre, Christophe Adelphe

(57) **Abrégé**

Ce système d'interrupteur comporte : - un interrupteur (110LS) ; - un dispositif (112) de commande de l'interrupteur (110LS), conçu pour fournir une commande (CMD) à l'interrupteur (110LS) afin d'alterner des phases d'ouverture et de fermeture de l'interrupteur (110LS) ; et - un dispositif (224) de détermination d'une température (Tj) de l'interrupteur (110LS). Le système d'interrupteur comporte en outre un dispositif de mesure (221) conçu pour fournir deux mesures (M1, M2) d'une caractéristique électrique (VCE) de l'interrupteur (110LS) pour respectivement les deux valeurs de mesure de la commande (CMD). Le dispositif de détermination de température (224) est conçu pour déterminer la température (Tj) de l'interrupteur (110LS) à partir des deux mesures (M1, M2) de la caractéristique électrique (VCE).

Le dispositif de commande (112) comporte : - un module de commande par défaut (205) ; - un module de génération de modulation (212) conçu pour, pendant la phase de mesure (PM), générer une modulation (mod) ; et - un module de modulation (220) conçu pour moduler la commande par défaut (CMD*) à partir de la modulation (mod), pendant la phase de mesure (PM).

## Description

La présente invention concerne un système d'interrupteur avec un dispositif de détermination de température, une installation électrique comportant un tel système d'interrupteur et un procédé correspondant.

L'invention s'applique plus particulièrement à un système d'interrupteur comportant un interrupteur, un dispositif de commande de l'interrupteur, conçu pour fournir une commande à l'interrupteur afin d'alterner des phases d'ouverture et de fermeture de l'interrupteur, et un dispositif de détermination d'une température de l'interrupteur.

Dans l'état de la technique, une première solution de réalisation du dispositif de détermination de température est de placer une thermistance, par exemple avec un coefficient de température négatif, à proximité de l'interrupteur et de mesurer la variation de résistance de la thermistance. Cependant, pour des raisons d'encombrement, il n'est pas toujours possible de placer la thermistance à proximité de l'interrupteur. Or, si la thermistance est trop éloignée de l'interrupteur, la mesure de température risque de ne pas être précise. De plus, la température mesurée par la thermistance n'est pas la température réelle de l'interrupteur.

Une deuxième solution, applicable dans le cas d'un interrupteur muni d'une diode de roue-libre, est d'injecter un courant dans la diode de roue libre et de mesurer une variation d'une tension aux bornes de l'interrupteur. Cette solution présente comme inconvénient de nécessiter un circuit d'injection de courant prenant de la place et augmentant le coût du système.

Par ailleurs, l'article « Experimental Evaluation of IGBT Junction Temperature Measurement via a Modified-VCE (ΔVCE_ΔVGE) Method with Series Résistance Removal », de Nick Baker, Francesco lannuzzo, Stig Munk-Nielsen (Aalborg University, Denmark), Laurent Dupont (SATIE (UMR 8029), IFSTTAR-COSYS, France) et Yvan Avenas (G2Elab (UMR 5269), France), publié dans CIPS 2016; 9th International Conférence on Integrated Power Electronics Systems, décrit un système d'interrupteur, du type comportant :
- un interrupteur ;
- un dispositif de commande de l'interrupteur, conçu pour fournir une commande à l'interrupteur afin d'alterner des phases d'ouverture et de fermeture de l'interrupteur et pour, pendant une phase de mesure, pour chaque portion de phase d'ouverture présente dans la phase de mesure ou bien pour chaque portion de phase de fermeture présente dans la phase de mesure, faire varier la commande entre deux valeurs de mesure ;
- un dispositif de mesure conçu pour fournir deux mesures d'une caractéristique électrique de l'interrupteur pour respectivement les deux valeurs de mesure de la commande ; et
- un dispositif de détermination d'une température de l'interrupteur à partir des deux mesures de la caractéristique électrique.

Il peut ainsi être souhaité de prévoir un système d'interrupteur qui permette de réaliser le dispositif de commande de manière simple et économique.

Il est donc proposé un système d'interrupteur du type précité, caractérisé en ce que le dispositif de commande comporte :
- un module de commande par défaut conçu pour fournir une commande par défaut, la commande fournie à l'interrupteur étant égale, en dehors de la phase de mesure, à cette commande par défaut ;
- un module de génération de modulation conçu pour, pendant la phase de mesure, générer une modulation ; et
- un module de modulation conçu pour moduler la commande par défaut à partir de la modulation, la commande fournie à l'interrupteur étant égale, pendant la phase de mesure, à la commande par défaut modulée à partir de la modulation.

Grâce à l'invention, il est simple de réaliser le dispositif de commande car il suffit d'ajouter à un dispositif de commande existant et fournissant le signal de commande par défaut, un module de génération de modulation et un module de modulation, ces deux fonctions pouvant être réalisées par des circuits électroniques simples.

De façon optionnelle, l'interrupteur présente une borne d'entrée de courant et une borne de sortie de courant, l'interrupteur est conçu lorsque ouvert, respectivement fermé, pour empêcher, respectivement permettre, un courant de le traverser depuis sa borne d'entrée de courant jusqu'à sa borne de sortie de courant, et la caractéristique électrique de l'interrupteur est une tension entre les bornes d'entrée et de sortie de courant.

De façon optionnelle également, la température de l'interrupteur est une température de jonction de l'interrupteur.

De façon optionnelle également, l'une des deux valeurs de mesure est une valeur de la commande par défaut.

De façon optionnelle également, la commande par défaut alterne entre une valeur de fermeture pendant chaque phase de fermeture et une valeur d'ouverture pendant chaque phase d'ouverture.

De façon optionnelle également, le module de modulation est conçu pour ajouter ou bien soustraire la modulation à la commande par défaut.

De façon optionnelle également, la modulation alterne entre une valeur nulle et une valeur non nulle.

De façon optionnelle également, le système d'interrupteur comporte en outre un module d'isolation galvanique entre le module de génération de modulation et l'interrupteur, par exemple entre le module de génération de modulation et le module de modulation.

De façon optionnelle également, le dispositif de commande est conçu pour alterner entre les deux valeurs de mesure sur plusieurs alternances, le dispositif de mesure est conçu pour fournir, pour chaque alternance, deux mesures de la caractéristique électrique pour respectivement les deux valeurs de mesure, et le dispositif de détermination de température est conçu pour déterminer la température de l'interrupteur à partir des deux mesures de chaque alternance.

Il est également proposé une installation électrique comportant :
- un système d'interrupteur selon l'invention ;
- un bras de commutation comportant l'interrupteur du système d'interrupteur et un autre interrupteur, les deux interrupteurs étant connectés l'un à l'autre en un point milieu.

Il est également proposé un procédé de détermination d'une température d'un interrupteur auquel est fournie une commande afin d'alterner des phases d'ouverture et de fermeture de l'interrupteur, comportant :
- pendant une phase de mesure, pour chaque portion de phase d'ouverture présente dans la phase de mesure ou bien pour chaque portion de phase de fermeture présente dans la phase de mesure, une variation de la commande entre deux valeurs de mesure ;
- une mesure d'une caractéristique électrique de l'interrupteur pour respectivement les deux valeurs de mesure de la commande, afin de respectivement obtenir deux mesures ; et
- une détermination de la température de l'interrupteur à partir des deux mesures de la caractéristique électrique ;
caractérisé en ce qu'il comporte, pour faire varier la commande entre les deux valeurs de mesure :
- la fourniture d'une commande par défaut, la commande fournie à l'interrupteur étant égale, en dehors de la phase de mesure, à cette commande par défaut ; et
- pendant la phase de mesure, la génération d'une modulation et la modulation de la commande par défaut à partir de la modulation, la commande fournie à l'interrupteur étant égale, pendant la phase de mesure, à la commande par défaut modulée à partir de la modulation.

L'invention sera mieux comprise à l'aide de la description qui va suivre, donnée uniquement à titre d'exemple et faite en se référant aux dessins annexés dans lesquels :
[Fig. 1] la figure 1 est une vue fonctionnelle d'une installation électrique mettant en œuvre l'invention,
[Fig. 2] la figure 2 est une vue fonctionnelle détaillant un dispositif de commande d'un interrupteur de l'installation de la figure 1, et un système de détermination d'une température de cet interrupteur,
[Fig. 3] la figure 3 regroupe des chronogrammes illustrant l'évolution au cours du temps de différentes grandeurs électriques, parmi lesquelles une commande de l'interrupteur,
[Fig. 4] la figure 4 est un schéma électrique du dispositif de commande et du système de détermination de température de la figure 2, selon un mode de réalisation de l'invention,
[Fig. 5] la figure 5 est un schéma blocs illustrant les étapes d'un procédé de mesure d'une température d'un interrupteur, selon un mode de réalisation de l'invention,
[Fig. 6] la figure 6 est un schéma blocs illustrant les étapes d'un procédé de mesure d'une température d'un interrupteur, selon un mode de réalisation de l'invention,
[Fig. 7] la figure 7 est un graphique illustrant une tension aux bornes d'un interrupteur en fonction d'un courant le traversant et de sa température de jonction,
[Fig. 8] la figure 8 est un schéma électrique illustrant un module de division de tension pouvant être utilisé dans le dispositif de commande de la figure 2, et
[Fig. 9] la figure 9 est un schéma électrique illustrant un module de modulation pouvant être utilisé dans le dispositif de commande de la figure 2.

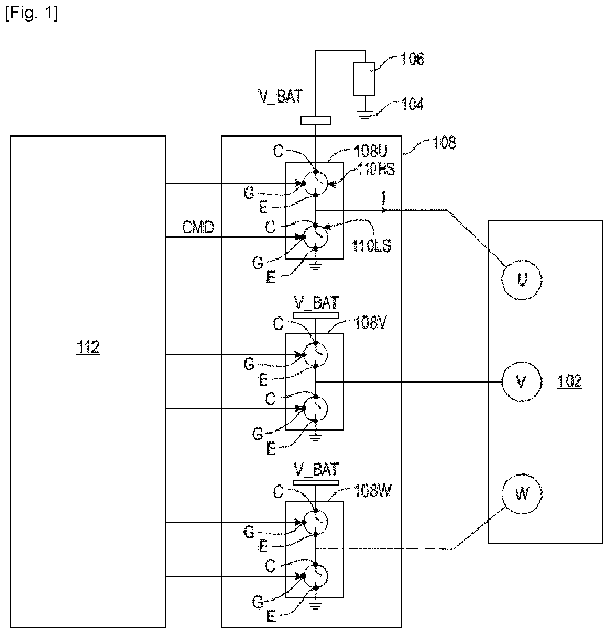

En référence à la figure 1, une installation électrique 100 mettant en œuvre l'invention va à présente être décrite.

L'installation 100 fait par exemple partie d'un véhicule automobile, tel qu'un véhicule à propulsion électrique ou bien hybride, électrique et thermique.

L'installation 100 comporte tout d'abord une machine électrique 102 pouvant être monophasée et présenter une seule phase, ou bien polyphasée et présenter plusieurs phases (trois phases U, V, W dans l'exemple décrit), par exemple des phases statoriques. La machine électrique 102 est conçue pour fonctionner en mode moteur et/ou en mode générateur.

L'installation 100 comporte en outre une source de tension 106 conçue pour présenter une tension continue V_BAT par rapport à une masse électrique 104 de l'installation 100. La source de tension 106 comporte par exemple une batterie. La tension V_BAT est généralement élevée, par exemple supérieure à 100 V.

L'installation 100 comporte en outre un convertisseur de tension 108 conçu pour réaliser une conversion entre la tension V_BAT et une tension alternative de chaque phase U, V, W. À cette fin, le convertisseur de tension 108 comporte des bras de commutation 108U, 108V, 108W respectivement dédiés aux phases U, V, W de la machine électrique 102 (un seul bras de commutation dans le cas où la machine électrique 102 est monophasée) et conçus pour alternativement connecter la phase U, V, W associée à la source de tension 106 (c'est-à-dire à la tension V_BAT) et à la masse électrique 104 (c'est-à-dire à la tension nulle). Lorsque la machine électrique 102 fonctionne en mode moteur, le convertisseur de tension 108 est conçu pour fonctionner en mode onduleur pour convertir la tension V_BAT en tensions de phase. Lorsque la machine électrique 102 fonctionne en mode générateur, le convertisseur de tension 108 est conçu pour fonctionner en mode redresseur pour convertir les tensions de phase en tension V_BAT, par exemple afin de recharger la source de tension 106.

Comme illustré sur la figure 1, le bras de commutation 108U comporte un interrupteur de côté haut 110HS (de l'anglais « High Side ») et un interrupteur de côté bas 110LS (de l'anglais « Low Side »). Chaque interrupteur 110HS, 110LS présente une borne d'entrée de courant C et une borne de sortie de courant E. La borne d'entrée de courant C de l'interrupteur de côté haut 110HS est connectée à la source de tension continue 106. La borne de sortie de courant E de l'interrupteur de côté haut 110HS et la borne d'entrée de courant C de l'interrupteur de côté bas 110LS sont connectés l'un à l'autre en un point milieu connecté à la phase U associée à ce bras de commutation 108U. La borne de sortie de courant E de l'interrupteur de côté bas 110LS est connectée à la masse électrique 104.

Un courant de phase I s'écoule depuis le point milieu vers la phase U associée au bras de commutation 108U. La phase U de la machine éclectique 102 présente une inductance très grande, de sorte que le courant de phase I varie très lentement.

Chaque interrupteur 110HS, 110LS présente en outre une borne de commande G destinée à recevoir une commande pour sélectivement ouvrir et fermer l'interrupteur 110HS, 110LS. Lorsque ouvert, respectivement fermé, l'interrupteur 110HS, 110LS est conçu pour empêcher, respectivement permettre, un courant de le traverser depuis sa borne d'entrée de courant C jusqu'à sa borne de sortie de courant E.

Dans l'exemple décrit, chaque interrupteur 110HS, 110LS comporte un transistor bipolaire à grille isolée (de l'anglais « Insulated Gate Bipolar Transistor », ou IGBT) présentant un collecteur formant la borne d'entrée de courant C, un émetteur formant la borne de sortie de courant E et une grille formant la borne de commande G. La commande de l'interrupteur 110HS, 110LS est alors sous la forme d'une tension VGE de la grille par rapport à l'émetteur.

Alternativement, d'autres types d'interrupteur transistor semi-conducteur pourraient être utilisés, comme un transistor à effet de champ à grille isolée (de l'anglais « Metal Oxide Semiconductor Field Effect Transistor » ou MOSFET, pouvant également être traduit par transistor à effet de champ à structure métal-oxyde-semi-conducteur).

Les autres bras de commutation 108V, 108W sont similaires au bras de commutation 108U, et ne seront donc pas décrits plus en détails.

L'installation 100 comporte en outre un dispositif 112 de commande des interrupteurs du convertisseur de tension 108, et en particulier des interrupteurs 110HS, 110LS. En particulier, le dispositif de commande 112 est conçu pour fournir une commande CMD à l'interrupteur de côté bas 110LS afin d'alterner des phases d'ouverture PO et de fermeture PF de l'interrupteur de côté bas 110LS. Dans l'exemple décrit, la commande CMD est la tension VGE. De manière similaire, le dispositif de commande 112 est conçu pour fournir une commande à l'interrupteur de côté haut 110HS afin d'alterner des phases d'ouverture et de fermeture de l'interrupteur de côté haut 110HS, en opposition des phases d'ouverture PO et de fermeture PF de l'interrupteur de côté bas 110LS.

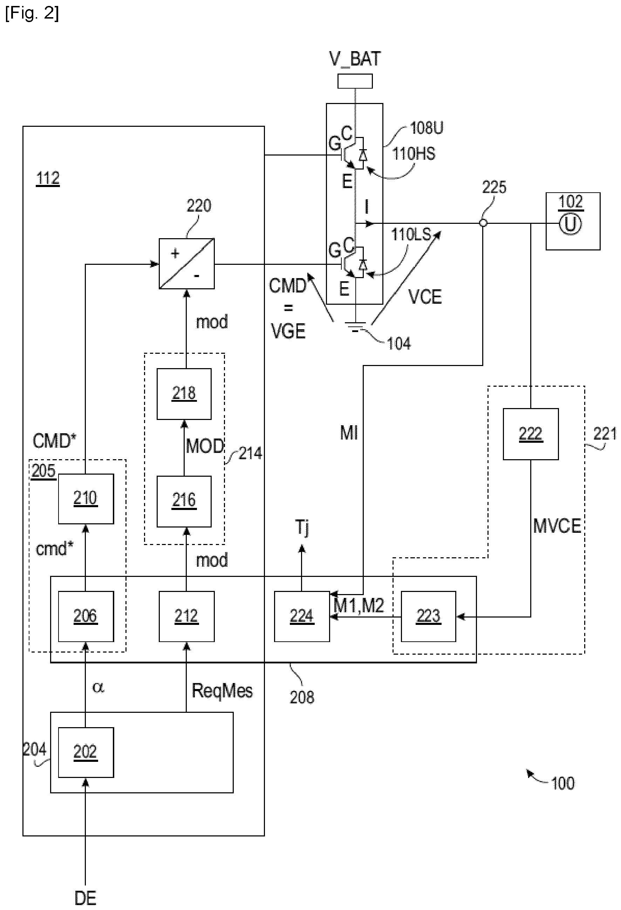

En référence à la figure 2, le dispositif de commande 112 comporte tout d'abord un module 202 de détermination d'un rapport cyclique α à partir de données d'entrée DE, comportant par exemple un ou plusieurs parmi : un couple de la machine électrique 102, une vitesse angulaire d'un rotor (non représenté) de la machine électrique 102 et une position angulaire du rotor de la machine électrique 102.

Dans l'exemple décrit, l'installation 100 comporte un microcontrôleur 204 implémentant le module de détermination de rapport cyclique 202.

Le dispositif de commande 112 comporte en outre un module de commande par défaut 205 conçu pour fournir une commande par défaut CMD* à partir du rapport cyclique α.

Le module de commande par défaut 205 comporte tout d'abord un module de de commande par défaut basse tension 206, conçu pour générer une commande par défaut basse tension cmd* à partir du rapport cyclique α. Dans l'exemple décrit, la commande par défaut basse tension cmd* est à modulation de largeur d'impulsion (de l'anglais « Pulse Width Modulation » ou PWM) et alterne entre 0 V et au plus 10 V. Dans l'exemple décrit, la commande par défaut basse tension cmd* alterne entre 0 V et 5 V.

Dans l'exemple décrit, l'installation 100 comporte un circuit logique programmable, tel qu'un FPGA 208 (de l'anglais « field-programmable gate array »), implémentant le module de commande par défaut basse tension 206.

Le dispositif de commande 112 comporte en outre un premier pilote 210 conçu pour amplifier la commande par défaut basse tension cmd* en la commande par défaut CMD*, qui est à haute tension. La commande par défaut CMD* est donc également à modulation de largeur d'impulsion. Dans l'exemple décrit, la commande par défaut CMD* alterne entre une valeur de fermeture VF, valant par exemple -15 V, commandant la fermeture de l'interrupteur de côté bas 110LS et une valeur d'ouverture VO, valant par exemple 15 V, commandant l'ouverture de l'interrupteur de côté bas 110LS.

Par ailleurs, le dispositif de commande 112 est conçu pour, pendant une phase de mesure PM, pour chaque portion de phase de fermeture PF présente dans cette phase de mesure PM, faire varier la commande CMD entre deux valeurs de mesure VF, VMES. Dans l'exemple décrit, le dispositif de commande 112 est conçu pour ne faire varier la commande CMD que pendant la ou les portions des phases de fermeture PF présentes dans la phase de mesure PM, et non pendant les portions de phases d'ouverture PO présentes dans la phase de mesure PM.

Pour cela, le dispositif de commande 112 comporte en outre un module de génération de modulation 212 conçu pour, pendant la phase de mesure PM, générer une modulation mod. Cette modulation mod est destinée à moduler la commande par défaut CMD* pendant les portions des phases de fermeture PF présentes dans la phase de mesure PM. Dans l'exemple décrit, la modulation mod est à modulation de largeur d'impulsion et alterne entre une valeur nulle (0 V) et une valeur de modulation vmod valant au plus 10 V, par exemple 5 V.

Dans l'exemple décrit, le module de génération de modulation 212 est implémenté par le FPGA 208, de sorte que la modulation mod alterne entre les deux mêmes valeurs que la commande par défaut basse tension cmd*.

Le dispositif de commande 112 comporte en outre de préférence un module d'isolation galvanique 214 conçu pour isoler galvaniquement le module de génération de modulation 212 de l'interrupteur 110LS et donc de la tension V_BAT.

Dans l'exemple décrit, le module d'isolation galvanique 214 comporte un deuxième pilote 216 conçu pour amplifier le signal de modulation mod en un signal de modulation haute tension MOD. Ce deuxième pilote 216 (comme le premier pilote 210) présente l'avantage de posséder une isolation galvanique.

Pour repasser le signal de modulation en basse tension, le module d'isolation galvanique 214 comporte en outre un module de division de tension 218 conçu pour fournir la modulation mod en divisant la modulation haute tension MOD.

Le dispositif de commande 112 comporte en outre un module de modulation 220 conçu pour moduler la commande par défaut CMD* à partir de la modulation mod. Par exemple, le module de modulation 220 est conçu pour ajouter ou bien soustraire la modulation mod à la commande par défaut CMD*. Dans l'exemple décrit, le module de modulation 220 est conçu pour soustraire la modulation mod à la commande par défaut CMD*.

L'installation 100 comporte en outre un module 221 de mesure d'une tension VCE présente entre les bornes d'entrée C et de sortie E de courant de l'interrupteur de côté bas 110LS. Le module de mesure 221 est conçu pour fournir au moins une mesure M1 de la tension VCE lorsque la commande CMD est à la valeur de mesure VF et au moins une mesure M2 de la tension VCE lorsque la commande CMD est à la valeur de mesure VMES.

Dans l'exemple décrit, le module de mesure 221 comporte un module 222 de suivi de la tension VCE conçu pour fournir en continu une mesure MVCE de la tension VCE, et un module d'acquisition 223 conçu pour réaliser, à un instant prédéfini, une mesure.

L'installation 100 comporte en outre un module 225 de mesure du courant de phase I, conçu pour fournir une mesure MI du courant de phase I.

L'installation 100 comporte en outre un module 224 de détermination d'une température de jonction Tj de l'interrupteur de côté bas 110LS à partir des mesures M1, M2 de la tension V_CE et de la mesure MI du courant de phase I.

Dans l'exemple décrit, les modules 223, 224 sont implémentés par le FPGA 208.

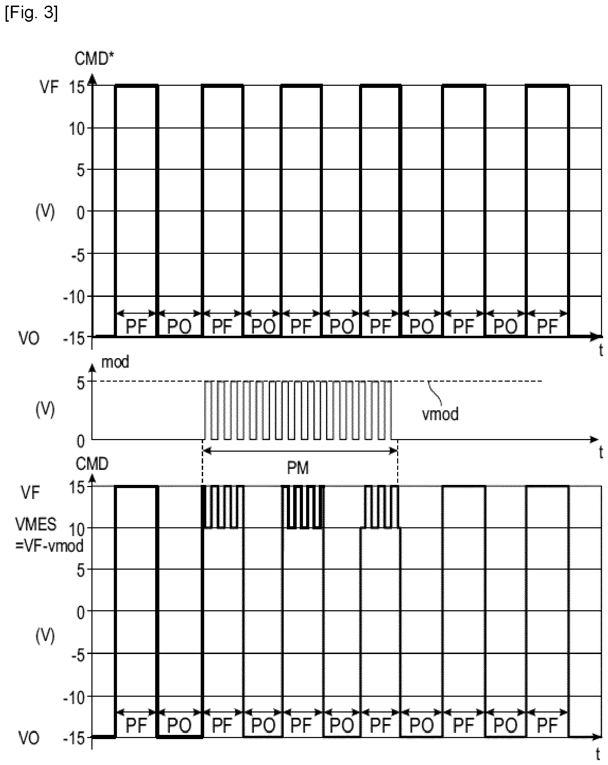

En référence à la figure 3, des exemples de commande par défaut CMD*, de modulation mod et de commande CMD sont illustrés.

En dehors des phases de mesure PM, la modulation mod reste à la valeur nulle de sorte qu'elle ne modifie pas la commande par défaut CMD*. Ainsi, la commande CMD fournie à l'interrupteur de côté bas 110LS est égale à la commande par défaut CMD* et alterne entre la valeur de fermeture VF pendant chaque phase de fermeture PF et la valeur d'ouverture VO pendant chaque phase d'ouverture PO.

Pendant chaque phase de mesure PM, la modulation mod alterne entre la valeur nulle et la valeur de modulation vmod. Ainsi, pendant chaque portion de phase de fermeture PF présente dans la phase de mesure PM, la commande CMD est égale à la valeur de fermeture VF lorsque la modulation mod est à sa valeur nulle (CMD = VF) et, lorsque la modulation mod est à sa valeur de modulation vmod, est égale à une valeur de mesure VMES égale à la différence entre la valeur de fermeture VF et la valeur de modulation vmod (CMD = VMES = VF - vmod).

Il sera apprécié que, pendant les phases d'ouverture PO présentes dans la phase de mesure PM, les moyens de modulation 220 sont conçus pour ne pas appliquer la modulation mod, de sorte que la commande CMD reste égale à la valeur d'ouverture VO.

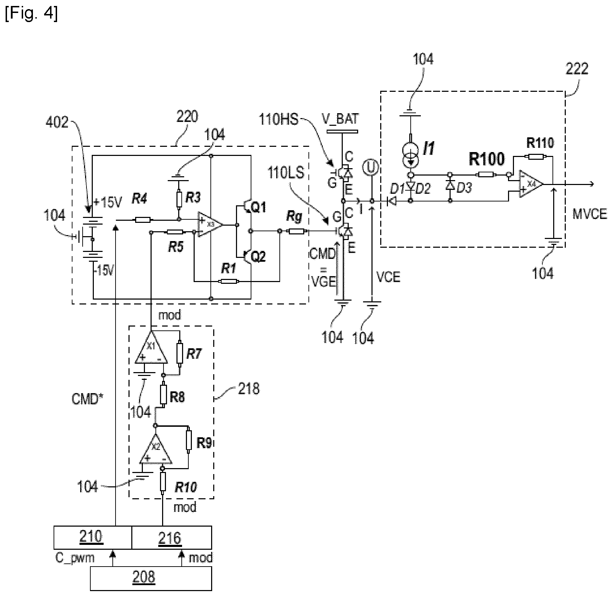

En référence à la figure 4, des exemples de réalisation des modules 218, 220 et 222 de la figure 2 vont à présent être décrits.

Dans cet exemple de réalisation, le module de division de tension 218 comporte deux circuits inverseur montés à la suite l'un de l'autre.

Le premier circuit inverseur comporte un amplificateur opérationnel X2 présentant une entrée positive connectée à la masse électrique 104 et une entrée négative. Le premier circuit inverseur comporte en outre une résistance R10 présentant une borne connectée à l'entrée négative et une autre borne connectée au deuxième pilote 216 pour recevoir la modulation haute tension MOD fournie par le deuxième pilote 216. Le premier circuit inverseur comporte en outre une résistance R9 connectée entre l'entrée négative et une sortie de l'amplificateur opérationnel X2.

Le deuxième circuit inverseur comporte un amplificateur opérationnel X1 présentant une entrée positive connectée à la masse électrique 104 et une entrée négative. Le deuxième circuit inverseur comporte en outre une résistance R8 connectée entre l'entrée négative de l'amplificateur opérationnel X1 et la sortie de l'amplificateur opérationnel X2. Le deuxième circuit inverseur comporte en outre une résistance R7 connectée entre l'entrée négative et une sortie de l'amplificateur opérationnel X1.

Par ailleurs, dans cet exemple de réalisation, le module de modulation 220 comporte un amplificateur opérationnel X3 et une source de tension 402 alimentant l'amplificateur opérationnel X3 entre +15 V et -15 V, c'est-à-dire entre les deux valeurs PF, PO de la commande par défaut CMD*.

Le module de modulation 220 comporte en outre une résistance R5 connectée entre une entrée négative de l'amplificateur opérationnel X3 et le module de division de tension 218 pour recevoir la modulation mod.

Le module de modulation 220 comporte en outre une résistance R3 connectée entre une entrée positive de l'amplificateur opérationnel X3 et la masse électrique 104, ainsi qu'une résistance R4 connectée entre l'entrée positive de l'amplificateur opérationnel X3 et le premier pilote 210 pour recevoir la commande par défaut CMD*.

Le module de modulation 220 comporte en outre deux transistors Q1, Q2 connectés à la suite l'un de l'autre en un point milieu, et aux bornes de la source de tension 402. Les transistors Q1, Q2 présentent des grilles connectées à une sortie de l'amplificateur opérationnel X3.

Le module de modulation 220 comporte en outre une résistance R1 connectée entre la borne négative de l'amplificateur opérationnel X3 et le point milieu des transistors Q1, Q2.

Le module de modulation 220 comporte en outre une résistance Rg connectée entre le point milieu des transistors Q1, Q2 et la grille G de l'interrupteur de côté bas 110LS.

Par ailleurs, dans cet exemple de réalisation, le module 222 de suivi de la tension VCE comporte tout d'abord un amplificateur opérationnel X4 dont une sortie présente la mesure MVCE de la tension VCE.

Le module 222 comporte en outre une résistance R110 connectée entre la sortie et une entrée négative de l'amplificateur opérationnel X4.

Le module 222 comporte en outre une diode D1 connectée entre une entrée positive de l'amplificateur opérationnel X4 et le point milieu du bras de commutation 108U, montée passante en direction de ce point milieu.

Le module 222 comporte en outre une résistance R100 connectée à l'entrée négative de l'amplificateur opérationnel X4 et une diode D3 connectée entre la résistance R100 et l'entrée positive de l'amplificateur opérationnel X4, passante en direction de la résistance R100.

Le module 222 comporte en outre une diode D2 connectée entre, d'une part, entre la résistance R100 et la diode D3 et, d'autre part, entre la diode D1 et l'entrée positive de l'amplificateur opérationnel X4, passante en direction de la diode D1 et l'entrée positive de l'amplificateur opérationnel X4.

Le module 222 comporte en outre une source de courant I1 connectée entre, d'une part, la masse électrique 104 et, d'autre part, entre la résistance R100 et la diode D2, pour injecter du courant en direction de la résistance R100 et la diode D2.

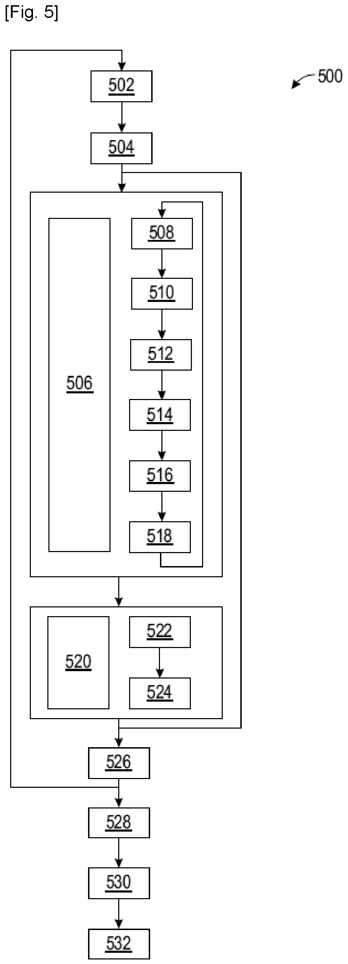

En référence à la figure 5, un exemple de procédé 500 de détermination de la température de jonction Tj de l'interrupteur de côté bas 110LS va à présent être décrit.

Initialement, au cours d'une étape 502, le système de commande 112 réalise une commande par défaut de l'interrupteur de côté bas 110LS. Lors de la commande par défaut, la modulation mod est nulle, de sorte que la commande CMD fournie par le module de modulation 220 est identique à la commande par défaut CMD*. Ainsi, l'interrupteur de côté bas 110LS se ferme lorsqu'il reçoit la commande CMD à la valeur de fermeture VF et s'ouvre lorsqu'il reçoit la commande à la valeur d'ouverture VO.

Au cours d'une étape 504, le module de génération de modulation 212 reçoit une requête de mesure ReqMes indiquant le début de la phase de mesure PM.

Au cours d'une étape 506, le module de commande par défaut 205 fournit la commande par défaut CMD* à la valeur de fermeture VF.

Parallèlement, les étapes 508 à 518 suivantes sont réalisées en boucle tant que la commande par défaut CMD* est à la valeur de fermeture VF.

Au cours d'une étape 508, le module de génération de modulation 212 fournit la modulation mod à la valeur de modulation vmod.

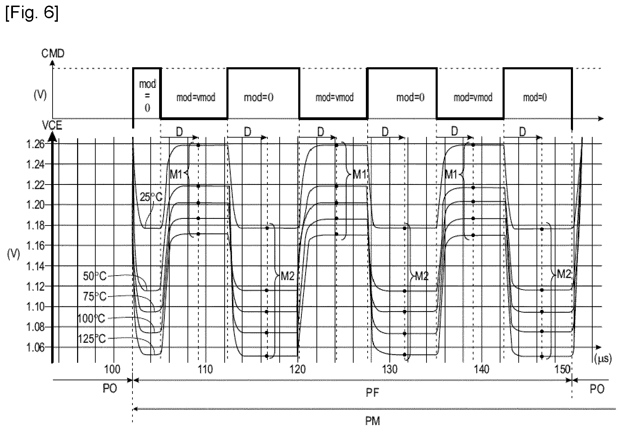

Au cours d'une étape 510, le module de modulation 220 fournit la commande CMD à la valeur de mesure VMES, égale à la différence entre la valeur de fermeture VF et la valeur de modulation vmod. Cette valeur de mesure VMES est suffisamment élevée pour que l'interrupteur de côté bas 110LS reste fermé. Cependant, en référence à la figure 6, la fourniture de la valeur de mesure VMES à l'interrupteur de côté bas 110LS provoque l'augmentation de la tension VCE puis sa stabilisation.

De retour à la figure 5, au cours d'une étape 512, le module de mesure 221 mesure la tension VCE stabilisée et fournit une mesure M1. Pour cela, en référence à la figure 6, le module de mesure 221 est par exemple conçu pour attendre une durée D prédéfinie après la fourniture de la modulation mod à la valeur vmod pour réaliser la mesure.

De retour à la figure 5, au cours d'une étape 514, le module de génération de modulation 212 fournit la modulation mod à la valeur nulle.

Au cours d'une étape 516, comme la modulation mod est nulle, le module de modulation 220 fournit la commande CMD à la valeur de fermeture VF de la commande par défaut CMD*. En référence à la figure 6, la fourniture de la valeur de fermeture VF à l'interrupteur de côté bas 110LS provoque la diminution puis la stabilisation de la tension VCE.

De retour à la figure 5, au cours d'une étape 518, le module de mesure 221 mesure la tension VCE stabilisée et fournit une mesure M2. Pour cela, en référence à la figure 6, le module de mesure 221 est par exemple conçu pour attendre à nouveau la durée D prédéfinie après la fourniture de la modulation mod à la valeur nulle pour réaliser la mesure.

De retour à la figure 5, au cours d'une étape 520, le module de commande par défaut 205 fournit la commande par défaut CMD* à la valeur d'ouverture VO.

Parallèlement, les étapes 522 et 524 suivantes sont réalisées en boucle tant que la commande par défaut CMD* est à la valeur d'ouverture VO.

Au cours d'une étape 522, comme la phase de mesure PM est toujours active, le module de génération de modulation 212 continue de fournir la modulation mod.

Cependant, au cours d'une étape 524, quel que soit la valeur de la modulation mod, le module de modulation 220 fournit la commande CMD à la valeur d'ouverture VO. En effet, comme l'amplificateur opérationnel X3 est alimenté par rapport à la valeur d'ouverture VO, il ne peut pas fournir en sortie une tension inférieure à cette valeur d'ouverture VO et fournit donc toujours en sortie la valeur d'ouverture VO.

Les étapes 506 à 524 sont répétées jusqu'à la fin de la phase de mesure PM.

Au cours d'une étape 526, la phase de mesure PM se termine.

Après la phase de mesure PM, le procédé 500 retourne à l'étape 502 de commande par défaut de l'interrupteur de côté bas 110LS. Parallèlement, au cours d'une étape 528, le module de détermination de température 224 réalise une moyenne des mesures M1, notée <M1> et une moyenne des mesures M2, notée <M2>.

Au cours d'une étape 530, le module de détermination de température 224 calcule la différence entre les moyennes <M1> et <M2> pour obtenir une différence de tension ΔVCE de l'interrupteur de côté bas 110LS.

Au cours d'une étape 532, le module 224 détermine la température de jonction Tj de l'interrupteur de côté bas 110LS à partir de la différence de tension ΔVCE.

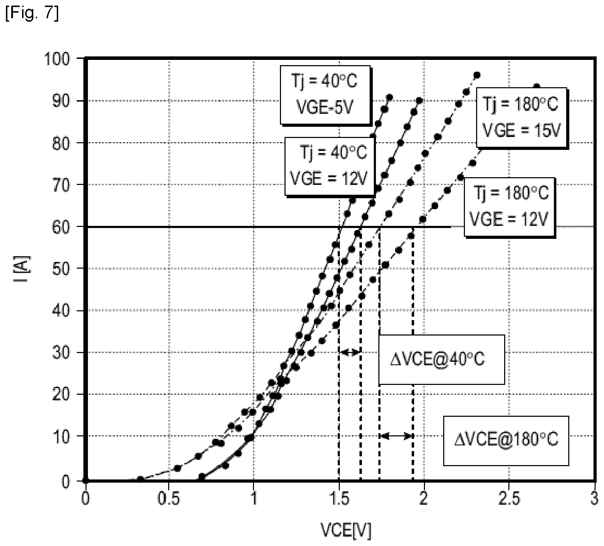

En effet, en référence à la figure 7, il sera apprécié que la différence de tension ΔVCE varie en fonction de la température Tj et du courant de phase I. Cependant, comme le courant de phase I est sensiblement constant du fait de l'inductance élevée de la phase, la différence de tension ΔVCE ne dépend sensiblement que de la température Tj pendant la phase de mesure PM. En revanche, le courant de phase I peut varier d'une phase de mesure PM à l'autre.

Ainsi, le module 224 de détermination de la température Tj comporte par exemple une cartographie prédéfinie reliant la température Tj au courant de phase I et à la différence de tension ΔVCE.

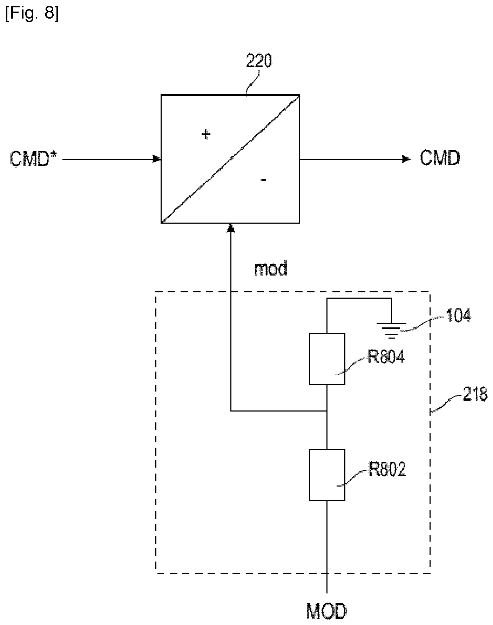

En référence à la figure 8, le module de division de tension 218 comporte, dans un autre mode de réalisation, un circuit diviseur de tension comportant une première résistance R802 dont une borne est conçue pour recevoir la modulation haute tension MOD, et une deuxième résistance R804 dont une borne est connectée à la masse électrique 104 et dont une autre borne est connectée à une autre borne de la résistance R802, ces deux autres bornes étant connectées au module de modulation 220 pour lui fournir la modulation mod.

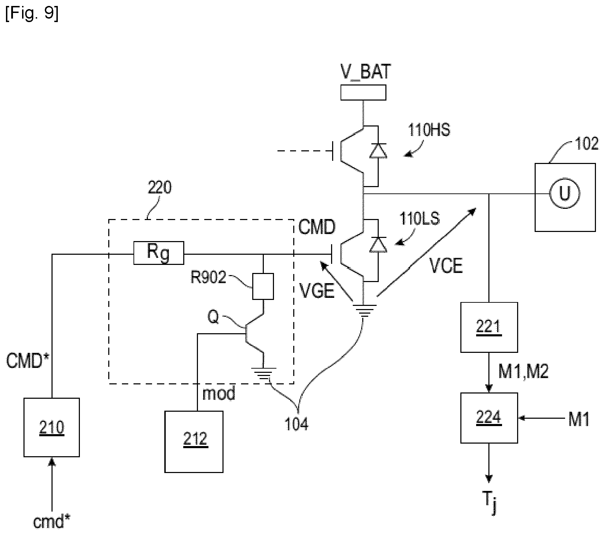

En référence à la figure 9, le module de modulation 220 comporte, dans un autre mode de réalisation, une résistance Rg dont une borne est connectée à la grille de l'interrupteur de côté bas 110LS et dont une autre borne est conçue pour recevoir la commande par défaut CMD*, un interrupteur Q de type transistor dont une borne de sortie de courant est connectée à la masse électrique 104, et une résistance R902 dont une borne est connectée à la grille de l'interrupteur de côté bas 110LS et dont une autre borne est connectée à une borne d'entrée de courant de l'interrupteur Q.

Lorsque l'interrupteur Q est ouvert la commande CMD est égale à la commande par défaut CMD*. Lorsque l'interrupteur Q est fermé, les résistance Rg et R902 forment un circuit diviseur de tension présentant un coefficient de division dépendant des valeurs des résistances Rg, R902, de sorte que la commande CMD est égale à la commande par défaut CMD* divisée par ce coefficient de division.

Il apparaît clairement qu'un système d'interrupteur tel que celui décrit précédemment permet une mesure fiable d'une température d'un interrupteur sans nécessiter de thermistance ou bien de circuit d'injection de courant dans la diode de roue libre.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

Par exemple, une autre caractéristique électrique de l'interrupteur 110LS pourrait être utilisée.

En outre, le module de commande 112 pourrait être conçu pour faire varier le signal de commande CMD pendant chaque portion de phase d'ouverture PO présente dans la phase de mesure PM, à la place des variations pendant les phases de fermeture PF ou bien en complément. Les variations de la caractéristique électrique résultant de ces variations du signal de commande CMD pendant les phases d'ouverture pourraient alors être utilisées pour déterminer la température Tj.

Par ailleurs, dans la présentation détaillée de l'invention qui est faite précédemment, les termes utilisés ne doivent pas être interprétés comme limitant l'invention aux modes de réalisation exposés dans la présente description, mais doivent être interprétés pour y inclure tous les équivalents dont la prévision est à la portée de l'homme de l'art en appliquant ses connaissances générales à la mise en œuvre de l'enseignement qui vient de lui être divulgué.

## Revendications

1. Système d'interrupteur comportant :
- un interrupteur (110LS) ;
- un dispositif (112) de commande de l'interrupteur (110LS), conçu pour fournir une commande (CMD) à l'interrupteur (110LS) afin d'alterner des phases d'ouverture (PO) et de fermeture (PF) de l'interrupteur (110LS) et pour, pendant une phase de mesure (PM), pour chaque portion de phase d'ouverture (PO) présente dans la phase de mesure (PM) ou bien pour chaque portion de phase de fermeture (PF) présente dans la phase de mesure (PM), faire varier la commande (CMD) entre deux valeurs de mesure (VF, VMES) ;
- un dispositif de mesure (221) conçu pour fournir deux mesures (M1, M2) d'une caractéristique électrique (VCE) de l'interrupteur (110LS) pour respectivement les deux valeurs de mesure (VF, VMES) de la commande (CMD) ; et
- un dispositif (224) de détermination d'une température (Tj) de l'interrupteur (110LS) à partir des deux mesures (M1, M2) de la caractéristique électrique (VCE) ;
**caractérisé en ce que** le dispositif de commande (112) comporte :
- un module de commande par défaut (205) conçu pour fournir une commande par défaut (CMD*), la commande (CMD) fournie à l'interrupteur (110LS) étant égale, en dehors de la phase de mesure (PM), à cette commande par défaut (CMD*) ;
- un module de génération de modulation (212) conçu pour, pendant la phase de mesure (PM), générer une modulation (mod) ; et
- un module de modulation (220) conçu pour moduler la commande par défaut (CMD*) à partir de la modulation (mod), la commande (CMD) fournie à l'interrupteur (110LS) étant égale, pendant la phase de mesure (PM), à la commande par défaut (CMD*) modulée à partir de la modulation (mod).

2. Système d'interrupteur selon la revendication 1, dans lequel l'interrupteur (110LS) présente une borne d'entrée de courant (C) et une borne de sortie de courant (E), dans lequel l'interrupteur (110LS) est conçu lorsque ouvert, respectivement fermé, pour empêcher, respectivement permettre, un courant de le traverser depuis sa borne d'entrée de courant (C) jusqu'à sa borne de sortie de courant (E), et dans lequel la caractéristique électrique de l'interrupteur est une tension (VCE) entre les bornes d'entrée et de sortie de courant (C, E).

3. Système d'interrupteur selon la revendication 1 ou 2, dans lequel la température (Tj) de l'interrupteur (110LS) est une température de jonction de l'interrupteur (110LS).

4. Système d'interrupteur selon l'une quelconque des revendications 1 à 3, dans lequel l'une (VF) des deux valeurs de mesure (VF, VMES) est une valeur (VF) de la commande par défaut (CMD*).

5. Système d'interrupteur selon la revendication 4, dans lequel la commande par défaut (CMD*) alterne entre une valeur de fermeture (VF) pendant chaque phase de fermeture (PF) et une valeur d'ouverture (VO) pendant chaque phase d'ouverture (PO).

6. Système d'interrupteur selon la revendication 4 ou 5, dans lequel le module de modulation (220) est conçu pour ajouter ou bien soustraire la modulation (mod) à la commande par défaut (CMD*).

7. Système d'interrupteur selon la revendication 6, dans lequel la modulation (mod) alterne entre une valeur nulle et une valeur non nulle (vmod).

8. Système d'interrupteur selon l'une quelconque des revendications 1 à 7, comportant en outre un module d'isolation galvanique (214) entre le module de génération de modulation (212) et l'interrupteur (110LS), par exemple entre le module de génération de modulation (212) et le module de modulation (220).

9. Système d'interrupteur selon l'une des revendications 1 à 8, dans lequel le dispositif de commande (112) est conçu pour alterner entre les deux valeurs de mesure (VF, VMES) sur plusieurs alternances, dans lequel le dispositif de mesure (221) est conçu pour fournir, pour chaque alternance, deux mesures (M1, M2) de la caractéristiques électrique (VCE) pour respectivement les deux valeurs de mesure (VF, VMES), et dans lequel le dispositif de détermination de température (224) est conçu pour déterminer la température (Tj) de l'interrupteur (110LS) à partir des deux mesures (M1, M2) de chaque alternance.

10. Installation électrique (100) comportant :
- un système d'interrupteur selon l'une des revendications 1 à 9 ;
- un bras de commutation (108U) comportant l'interrupteur (110LS) du système d'interrupteur et un autre interrupteur (110HS), les deux interrupteurs étant connectés l'un à l'autre en un point milieu.

11. Procédé de détermination d'une température (Tj) d'un interrupteur (110LS) auquel est fournie une commande (CMD) afin d'alterner des phases d'ouverture (PO) et de fermeture (PF) de l'interrupteur (110LS), comportant :
- pendant une phase de mesure (PM), pour chaque portion de phase d'ouverture (PO) présente dans la phase de mesure (PM) ou bien pour chaque portion de phase de fermeture (PF) présente dans la phase de mesure (PM), une variation de la commande (CMD) entre deux valeurs de mesure (VF, VMES) ;
- une mesure d'une caractéristique électrique (VCE) de l'interrupteur (110LS) pour respectivement les deux valeurs de mesure (VF, VMES) de la commande (CLS), afin de respectivement obtenir deux mesures (M1, M2) ; et
- une détermination de la température (Tj) de l'interrupteur (110LS) à partir des deux mesures (M1, M2) de la caractéristique électrique (VCE) ;
**caractérisé en ce qu'**il comporte, pour faire varier la commande (CMD) entre les deux valeurs de mesure (VF, VMES) :
- la fourniture d'une commande par défaut (CMD*), la commande (CMD) fournie à l'interrupteur (110LS) étant égale, en dehors de la phase de mesure (PM), à cette commande par défaut (CMD*) ; et
- pendant la phase de mesure (PM), la génération d'une modulation (mod) et la modulation de la commande par défaut (CMD*) à partir de la modulation (mod), la commande (CMD) fournie à l'interrupteur (110LS) étant égale, pendant la phase de mesure (PM), à la commande par défaut (CMD*) modulée à partir de la modulation (mod).
